# EUROPÄISCHE PATENTSCHRIFT

(11) **EP 1 625 911 B1**
(45) Veröffentlichungstag und Bekanntmachung des Hinweises auf die Patenterteilung: **10.10.2007**
(21) Anmeldenummer: 04019097.7
(22) Anmeldetag: 11.08.2004
(51) Int. Cl.: B23K 20/00, H01L 21/00, H01L 21/607, B23Q 15/22, G06T 7/00, G05B 19/18

(54) **Drahtbonder mit einer Kamera, einer Bildverarbeitungseinrichtung, Speichermittel und Vergleichermittel und Verfahren zum Betrieb eines solchen**
Wire bonder with a camera, a device for image treatment, memoires et comparing means and process using this wire bonder
Appareil de microcablage avec une caméra, un dispositif de traitement d'images, des mémoires et des moyens de comparaison et méthode pour faire fonctionner un tel appareil

(43) Veröffentlichungstag der Anmeldung: 15.02.2006
(73) Patentinhaber: F&K Delvotec Bondtechnik GmbH, 85521 Ottobrunn (DE)
(72) Erfinder: Farassat, Farhad, Dr.-Ing., 82024 Taufkirchen (DE)
(74) Vertreter: Popp, Eugen

(56) Entgegenhaltungen:
- EP-A- 1 352 701
- US-A1- 2001 016 062
- US-A1- 2003 098 426
- US-B1- 6 449 516
- PATENT ABSTRACTS OF JAPAN Bd. 017, Nr. 034 (M-1357), 22. Januar 1993 (1993-01-22) & JP 04 256550 A (SEIBU ELECTRIC & MACH CO LTD), 11. September 1992 (1992-09-11)

## Beschreibung

Die Erfindung betrifft einen Drahtbonder nach dem Oberbegriff des Anspruchs 1 sowie ein Verfahren zum Betrieb eines solchen (siehe, z.B., US-A1-6 449 516).

Drahtbonder dieser Art sind bekannt; im Hinblick auf den eigentlichen Arbeitsabschnitt und die Arbeitsabläufe eines solchen Drahtbonders wird etwa hingewiesen auf die EP 0 649 701 B1 der Anmelderin. Speziell eine Bonddraht-Schneidvorrichtung eines derartigen Drahtbonders wird beschrieben in der EP 1 352 701 A1 der Anmelderin.

Solche Drahtbonder realisieren mit hoher Geschwindigkeit einen Arbeitsablauf, bei dem mehrere empfindliche Teile in exakte Lagebeziehungen zueinander gebracht und für vorbestimmte Zeit sowie mit vorbestimmter Andruckkraft gehalten werden müssen. Eine fehlerfreie Arbeitsweise solcher Vorrichtungen, die qualitativ einwandfreie Bondverbindungen zum Ergebnis hat, erfordert daher die präzise Einstellung der Lage- und Winkelbeziehungen der wesentlichen Komponenten, nämlich insbesondere des Bondwerkzeuges, der Bonddrahtführung und, sofern vorhanden, des Messers einer integrierten Bonddraht-Schneidvorrichtung. Da sich über dies die Lage- und Winkelbeziehungen dieser Vorrichtungskomponenten im Dauerbetrieb nach und nach ändern können, besteht auch bei einwandfreier Anfangs-Einstellung eine gewisse Gefahr von späteren Fehleinstellungen und daraus resultierenden Qualitätseinbußen im Produktionsprozess. Überdies können Beschädigungen der genannten Komponenten, etwa Deformationen des Stempels, Brüche oder Verbiegungen des Messers oder schlitzförmige Erweiterungen des Innenraumes der Bonddrahtführung, auftreten.

Um derartige Qualitätseinbußen mit hoher Sicherheit zu verhindern, ist es daher in der Praxis üblich, dass hochqualifizierte Spezialisten neben der Anfangs-Einstellung auch in bestimmten Abständen Überprüfungen der Lage- und Winkelbeziehungen und Unversehrtheit der erwähnten Komponenten einer Bondvorrichtung vornehmen. Diese Praxis ist relativ zeit- und kostenaufwendig und natürlich mit unerwünschten Unterbrechungen des Produktionsprozesses verbunden.

Die US 2003/016,062 A1 beschreibt einen Drahtbonder bzw. ein Drahtbondverfahren mit xy-Steuerung der Positionszuordnung zwischen Bondstellen und Bondkopf aufgrund einer Kamera-Überwachung des Bondbereiches, einschließlich der Kamera-Erfassung einer Werkzeugkante.

Aus Patent Abstracts of Japan Bd.-Nr. 017, Bd.-Nr. 034 (M-1375), 22. Januars 1993, ist eine Erfassungseinrichtung zur Überwachung der Spitze eines Schneidwerkzeuges innerhalb einer NC-gesteuerten Werkzeugmaschine mittels einer CCD-Kamera bekannt.

Der Erfindung liegt daher die Aufgabe der Bereitstellung eines verbesserten Drahtbonders der gattungsgemäßen Art bzw. eines verbesserten Betriebsverfahrens zugrunde, mit denen ein hohes Niveau an Qualitätssicherung im Bondprozess mit niedrigem Wartungs- und Kostenaufwand erreicht werden kann.

Diese Aufgabe wird in ihrem Vorrichtungsaspekt durch einen Drahtbonder mit den Merkmalen des Anspruchs 1 und in ihrem Verfahrensaspekt durch ein Verfahren mit den Merkmalen des Anspruchs 6 gelöst. Zweckmäßige Fortbildungen des Erfindungs-gedankens sind Gegenstand der abhängigen Ansprüche.

Die Erfindung schließt den wesentlichen Gedanken ein, einer am Drahtbonder vorgesehenen Kamera mit nachgeschalteter Bildverarbeitungseinrichtung Speicher- und Verarbeitungsmittel zur Nutzung aufgenommener Bilder zur Kontrolle der räumlichen Lage bzw. von Lagebeziehungen wesentlicher Arbeitseinrichtungen des Bonders zuzuordnen. Sie schließt weiter den Gedanken ein, in der Bildverarbeitungseinrichtung Speichermittel zur Speicherung von entsprechenden Solldaten bzw. Sollbildern von vorab festgelegten Positionen des Bondwerkzeuges bzw. der Bonddrahtführung und/oder wahlweise des Messers oder eines überstehenden Bonddraht-tails einer Bonddraht-Schneidvorrichtung vorzusehen. Alternativ oder zusätzlich sind Speichermittel zur Speicherung von Lagebeziehungen zwischen den genannten Komponenten oder zwischen einer oder mehreren dieser Komponenten einer Substratoberfläche vorgesehen.

Weiterhin schließt die Erfindung den Gedanken ein, Vergleichermittel zum Vergleich der erwähnten Solldaten oder Sollbilder mit aktuellen Positionsdaten oder Ist-Bildern der entsprechenden Komponenten oder des Bonddraht-tails vorzusehen, die bei Nachweis einer signifikanten Abweichung zwischen Solldaten und Positionsdaten bzw. Soll- und Ist-Bildern ein Steuer- oder Warnsignal ausgeben. Diese Vergleichermittel werden mit einer geeigneten Steuerung betrieben, um zumindest in regelmäßigen Abständen, erforderlichenfalls aber auch kontinuierlich während eines Bondprozesses, eine Kontrolle der Positionen bzw. Lagebeziehungen auszuführen und unzulässige Abweichungen hinreichend schnell zu erfassen.

Mit dem erwähnten Ausgangssignal kann, in einer einfacheren Ausführung der Erfindung, ein Alarm bewirkt und qualifiziertes Bedienpersonal zum Eingreifen veranlasst werden. Ein solches Eingreifen ist insbesondere erforderlich, wenn Beschädigungen der relevanten Werkzeuge nachgewiesen werden, die zu (insbesondere verborgenen) Qualitätsfehlern im Bondprozess führen könnten und daher einen Austausch des entsprechenden Werkzeugs erfordern. In einer anspruchsvolleren Ausführung der Erfindung geben die Vergleichermittel hinreichend differenzierte Steuersignale aus, deren Charakter mindestens bis zu einem gewissen Grade die Art der Abweichung der Ist-Positionsdaten repräsentiert und die automatische oder interaktiv gesteuerte Korrektur der Position der betroffenen Komponente(n) auslösen.

In dem vorgeschlagenen Drahtbonder sind zumindest ein erster, zweiter und dritter Speicherbereich zur Speicherung von Solldaten bzw. Soll-Bildern des Bondwerkzeuges, der Bonddrahtführung und des Messers vorgesehen und die Vergleichermittel umfassen eine erste, zweite und dritte Vergleichereinheit zum Vergleich der im ersten bis dritten Bereich gespeicherten Solldaten (oder Sollbilder) mit aktuellen Positionsdaten bzw. Bildern der entsprechenden Komponenten. Es kann auch eine Ausführung sinnvoll sein, bei der in bestimmten Speicherbereichen Datensätze (etwa zu einer Werkzeug-Sollposition) und in anderen Bilder (etwa zur Soll-Kontur eines unbeschädigten Werkzeuges) als Basis für eine Vergleichs-Verarbeitung mit aktuell aufgenommenen Daten bzw. Bildern gespeichert sind.

Schließlich ist hierbei eine logische Verarbeitungseinheit zur Verknüpfung von primär separat vorliegenden Ausgangssignalen der Vergleichereinheiten vorgesehen, die das erwähnte Steuer-Warnsignal dann ausgibt, wenn eine vorbestimmte Kombination von Ausgangssignalen der ersten bis dritten Vergleichereinheit gegeben ist. Bei dieser Ausführung ist es in vorteilhafter Weise möglich, durch eine geeignete Schwellwertverarbeitung in Verbindung mit nachgeschalteter logischer Verarbeitung "unschädliche" Veränderungen der absoluten Position bestimmter Komponenten des Drahtbonders wirkungslos zu lassen, während insbesondere kritische Veränderungen von Lagekoordinaten der genannten Werkzeuge (oder zwischen einem oder mehreren dieser Werkzeuge und dem Bondsubstrat) einen lahm- oder einen selbsttätigen Korrekturvorgang auslösen.

In einer weiter vorteilhaften Ausführung sind die Speichermittel zur Speicherung jeweils mehrerer Sätze Soll-Daten oder mehrerer Soll-Bilder des Bondwerkzeuges und/oder der Bonddrahtführung und/oder des Messers in zulässigen Betriebslagen und die Vergleichermittel zur Vergleichs-Verarbeitung der mehreren Soll-Datensätze oder Soll-Bilder mit jeweils einem Ist-Datensatz oder Ist-Bild nach einem vorbestimmten Vergleichsalgorithmus ausgebildet. Der genannte Vergleichsalgorithmus ist derart ausgestattet, dass das erwähnte Steuer- bzw. Warnsignal dann ausgegeben wird, wenn eine vorbestimmte Menge von Abweichungen zwischen Soll- und Positionsdaten bzw. Soll- und Ist-Bildern vorliegt.

Bei dieser Ausführung der Erfindung wird dann also im Bondprozess gewissermaßen eine vorgespeicherte Menge von zulässigen räumlichen Lagen der relevanten Werkzeuge/Komponenten oder von Lagebeziehungen zwischen diesen bzw. einem oder mehreren von ihnen und dem Substrat sequenziell mit dem entsprechenden Ist-Zustand verglichen. Wird eine hinreichende Nicht-Übereinstimmung festgestellt, so wird der Alarm- oder Korrekturvorgang ausgelöst.

Von besonderer Relevanz sind Höhen- und Neigungswerte des Bondwerkzeuges, der Bonddrahtführung und/oder des Messers im Raum (als Absolut-Werte und/oder Abstandswerte und Winkeldifferenzen zwischen mindestens zweien dieser Komponenten und/oder mindestens einer dieser Komponente und der Substratoberfläche). Entsprechend werden bevorzugt, derartige Daten als Solldaten gespeichert und mittels geeigneter Positionsdaten-Berechnungsmittel aus den Ausgangssignalen der Bildverarbeitungseinheit übermittelt und anschließend die einander entsprechenden Soll- und Istdaten dem oben erwähnten Vergleich unterzogen. Relevant sind darüber hinaus vollständige Abbildungen oder Konturen des wedge, der Bonddrahtführung und/oder des Messers oder auch des Bonddraht-tail, um beim Betrieb des Drahtbonders auftretende Beschädigungen bzw. unzulässigen Verschleiß dieser Teile nachweisen und ein Alarmsignal zum Austausch erzeugen zu können.

Neben der oben erwähnten Korrektur von Lageparametern bzw. Lagebeziehungen der Werkzeug-Komponenten kommen auch sonstige Korrekturen im Rahmen des Bondprozesses, etwa bei der Einstellung der Bondkraft, zum Ausgleich von Positionsänderungen in Betracht. Solche können mit einer partiellen Rückstellung der Position bzw. Positionsbeziehungen kombiniert sein, bis zu einem gewissen Grade die letzteren aber ersetzen.

Vorteile und Zweckmäßigkeiten der Erfindung ergeben sich im übrigen aus der nachfolgenden Beschreibung bevorzugter Ausführungsbeispiele und -aspekte anhand der Figuren. Von diesen zeigen:
- Fig. 1: eine Seitenansicht einer Ausführungsform einer Vorrichtung zum Drahtbonden (Drahtbonder),
- Fig. 2: eine Draufsicht auf die Ausführungsform einer Vorrichtung nach Fig. 1 gemäß Pfeil II,
- Fig. 3: eine Vorderansicht auf die Ausführungsform einer Vorrichtung nach Fig. 1
- gemäß Pfeil III,
- Fig. 4: die Anfangsphase eines Verfahrensablaufes eines bekannten Drahtbondverfahrens und
- Fig. 5: die schematische Darstellung eines Ausführungsbeispiels der Erfindung.

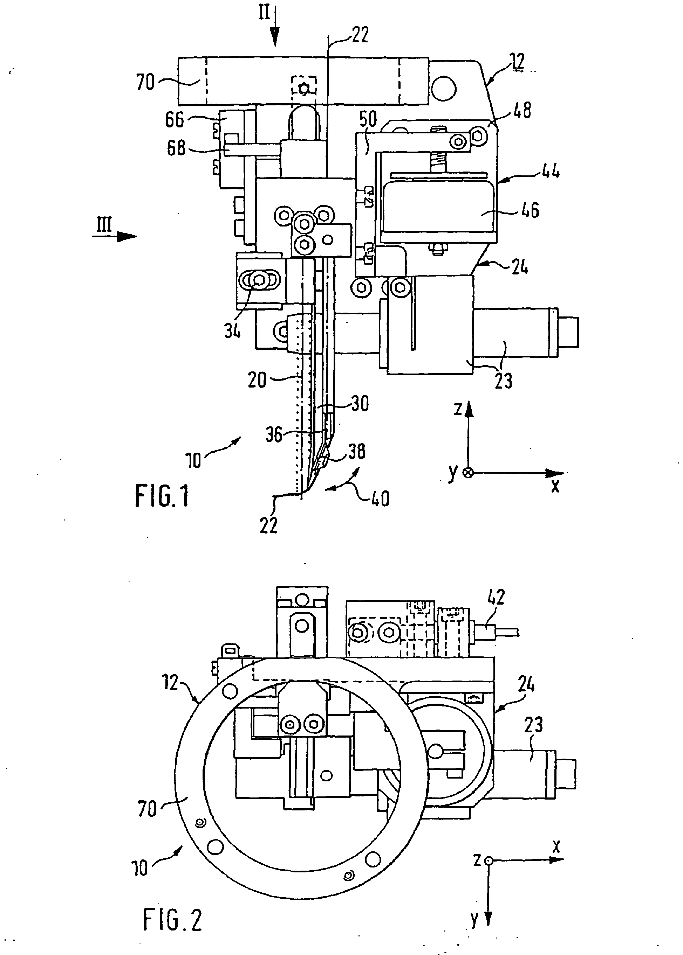

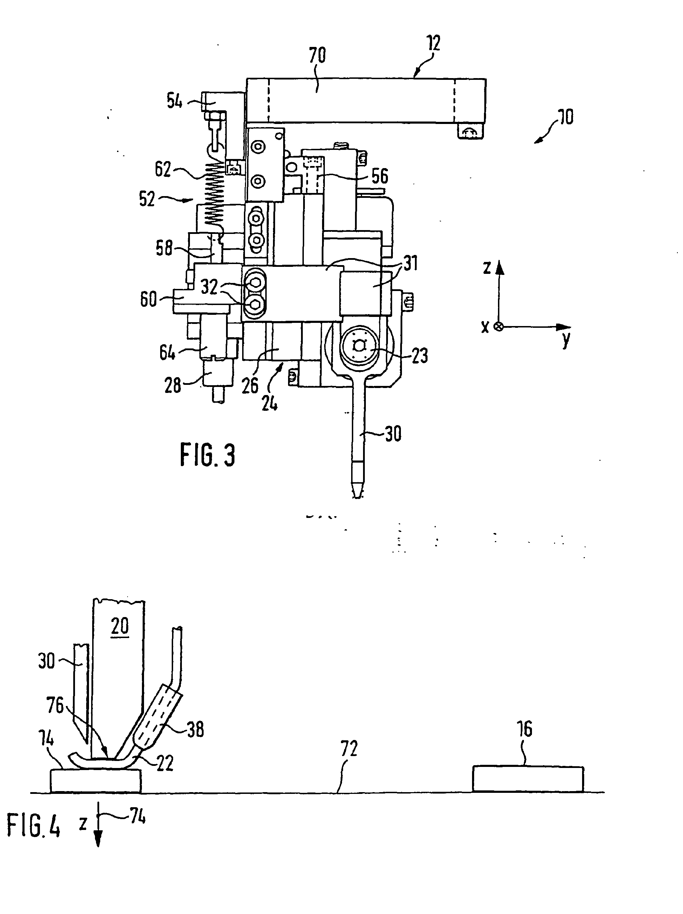

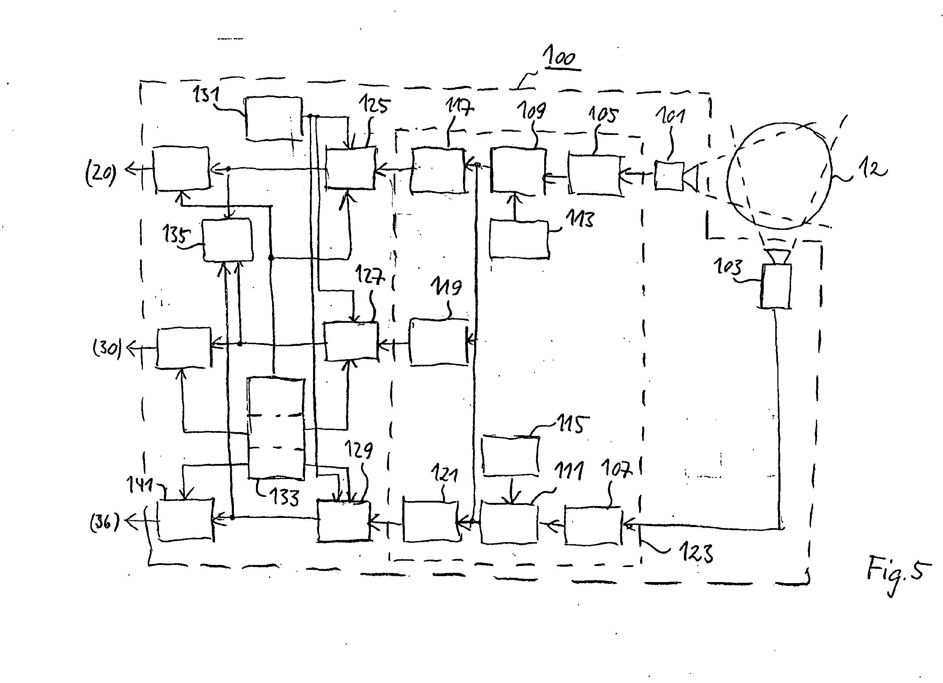

Die in den Fig. 1 bis 3 dargestellte Vorrichtung 10 zum Drahtbonden umfasst einen Bondkopf 12, der über einen nicht dargestellten Antrieb senkrecht zu einer Kontaktfläche 14 bzw. 16 (vgl. Fig. 4) entsprechend der z-Achse auf- und abbewegbar ist. Die Kontaktfläche 14 bzw. 16 befindet sich auf einer Unterlage 18 (vgl. Fig. 4), die in Richtung etwa quer zur z-Achse des Bondkopfes 12 unter Positionierung der Kontaktfläche 14 bzw. 16 gegenüber dem Bondkopf 12 bewegbar ist. Zusätzlich umfasst die erfindungsgemäße Vorrichtung 10 zum Drahtbonden eine Einrichtung zur Steuerung (ebenfalls nicht dargestellt) des Antriebs für den Bondkopf 12.

Der Bondkopf 12 umfasst einen Stempel (wedge) 20, der einen Bond-Draht 22 gegen die Kontaktfläche 14 bzw. 16 presst und über einen Transducer 23 ultraschallerregbar ist. Der Stempel 20 selbst ist parallel zur Bewegungsrichtung des Bondkopfes 12, d.h. in Richtung der z-Achse an diesem linear verschiebbar gelagert.

Zu diesem Zweck ist der Stempel 20 an einem Führungsschlitten 24 befestigt, der parallel zur Bewegungsrichtung des Bondkopfes 12, d.h. in Richtung der z-Achse von diesem linear verschiebbar aufgenommen ist. Der Führungsschlitten 24 für den Stempel 20 ist über eine Präzisionslinearführung 26 am Bondkopf verschiebbar gelagert.

Hierdurch ist eine hohe Maßgenauigkeit und Bruchsicherheit beim Drahtbonden sichergestellt.

Weiterhin ist der Bondkopf 12 mit einem Sensor 28 zur Bestimmung bzw. Erfassung der sogenannten "touch-down"-Höhe versehen, der dem Stempel 20 zugeordnet ist. Der Sensor 28 ist mit dem Antrieb für den Bondkopf 12 über die Einrichtung zu dessen Steuerung gekoppelt.

Des weiteren ist am Bondkopf 12 ein Messer 30 befestigt, das dem Stempel 20 zur, insbesondere teilweisen, Durchtrennung des Drahtes 22 zugeordnet ist. Sofern der Bonddraht 22 ein Dünndraht aus Gold oder dergleichen ist, kann auf ein solches Messer 30 verzichtet werden. Das Messer 30 kommt also in erster Linie beim Dickdrahtbonden zum Einsatz.

Zum einen ist das Messer 30 am Bondkopf 12 in dessen Bewegungsrichtung bzw. in Richtung der z-Achse über einen Messerhalter 31 mittels Schrauben, hier Innensechskantschrauben 32, einstellbar befestigt. Zum anderen ist das Messer 30 am Bondkopf 12 aber auch in Richtung senkrecht zur z-Achse (x-Achse) einstellbar befestigt, und zwar hier mit einer Schraube, nämlich Innensechskantschraube 34. Auf diese Weise kann das Messer 30 in Bezug auf den Stempel 20 derart angeordnet werden, dass das Messer 30 auf den Draht 22 in Drahtzuführungsrichtung hinter oder - wie in den Figuren 1 bis 3 dargestellt - vor dem Stempel 20 einwirkt. Das in den Figuren 1 bis 3 gezeigte Messer 30 ist zwischen dem Stempel 20 einerseits und einem sich parallel zum Stempel 20 erstreckenden Drahtführungsröhrchen 36 (Kapillare) andererseits angeordnet.

Das Drahtführungsröhrchen 36 ist am Führungsschlitten 24 befestigt und dementsprechend mit dem Stempel 20 mitbewegbar. Wie aus Fig. 1 deutlich hervorgeht, ist am unteren freien Ende des Führungsröhrchens 36 eine Führungshülse 38 zur Ausrichtung des Drahtes 22 hin zum freien unteren Ende bzw. zur Kontaktfläche des Stempels 20 vorgesehen. Die Führungshülse 38 ist kapillarenförmig ausgebildet und im vorliegenden Fall federelastisch ans Führungsröhrchen angelenkt. Die Führungshülse 38 ist insofern gemäß Doppelpfeil 40 in Fig. 1 verschwenkbar am Führungsröhrchen 36 angebracht, so dass beim Trennschnitt des Drahtes die Führungshülse 38 aus der Bewegungsbahn des Messers 30 von diesem herausbewegbar ist bzw. sich nach Beendigung des Trennvorganges in die Bewegungsbahn des Messers unter federelastischer Abstützung an diesem wieder selbsttätig hineinbewegt. Das Führungsröhrchen 36 selbst ist ebenso wie das Messer 30 am Bondkopf in Richtung senkrecht zur z-Achse, d.h. in Richtung der x-Achse mittels Schrauben einstellbar befestigt.

Darüber hinaus ist dem Messer 30 ein Sensor 42 zur Einstellung des maximalen Messerhubes in Bewegungsrichtung des Bondkopfes 12 zugeordnet. Mit dem Sensor 42 kann ein ungewolltes, gegebenenfalls vollständiges Durchtrennen des Drahtes 22 durch das Messer 30 bzw. auch ein ungewolltes Eintauchen des Messers 30 in das Substrat oder in elektrische bzw. elektronische Bauelemente zuverlässig vermieden werden.

Zwischen dem Bondkopf 12 und dem Führungsschlitten 24 ist weiterhin eine Einrichtung 44 zur Einstellung und Veränderung des sogenannten "Bondgewichts", d.h. des beim Bonden den Draht 22 durch den Stempel 20 beaufschlagenden "Gewichts" angeordnet. Die Gewichtseinstellungseinrichtung 44 umfasst eine Magnetfeld-Erzeugungsanordnung 46, 48, 50, die einen Kraftfluss zwischen dem Bondkopf 12 und dem Führungsschlitten 24 herstellt, welcher einstellbar und etwa parallel zur Bewegungsrichtung des Bondkopfes 12 beziehungsweise zur z-Richtung wirksam ist. Zu diesem Zweck weist die erwähnte Anordnung einerseits einen mit dem Führungsschlitten 24 fest verbundenen Hubmagneten 46 und andererseits einen über einen Winkel 48 mit dem Bondkopf 12 fest verbundenen Anker 50 auf.

Zwischen dem Bondkopf 12 und dem Führungsschlitten 24 für den Stempel 20 ist eine Einrichtung 52 zur Aufbringung einer Kraft angeordnet, die entgegen der Wirkung der Gewichtseinstellungseinrichtung 44 in Richtung der z-Achse wirksam ist. Diese Kraftaufbringungseinrichtung 52 umfasst zum einen ein Aufnahmeelement 54, das über einen Aufnahmewinkel 56 mit dem verschiebbar gelagerten Führungsschlitten 24 fest verbunden ist, und ein Halteelement 58, das über einen Lagerbock 60 oder dergleichen am Bondkopf 12 befestigt ist. Zwischen dem mit dem Bondkopf 12 verbundenen Halteelement 58 und dem an dem Führungsschlitten 24 angebrachten Aufnahmeelement 54 ist eine Zugfeder 62 angeordnet, deren Zugkraft über eine Einstellschraube 64, welche mit dem Halteelement 58 verbunden ist, einstellbar ist.

Die Kraftaufbringungseinrichtung 52 ist weiterhin mit einem Mikroschalter 66 versehen, der zur Begrenzung der Relativbewegung zwischen dem Bondkopf 12 und dem Führungsschlitten 24 für den Stempel 20 vorgesehen ist. Der Mikroschalter 66 ist entsprechend Fig. 1 von einem Zylinderstift 68 betätigbar, der über den Aufnahmewinkel 56 mit dem Führungsschlitten 24 fest verbunden ist.

Um den Bondkopf 12 an dessen nicht gezeigtem Antrieb in beliebiger Ausrichtung um dessen z-Achse in einer zu der Unterlage 18 parallelen Ebene, die von der x-Achse und der y-Achse aufgespannt ist, zu befestigen, ist der Bondkopf 12 zusätzlich mit einem Drehrahmen 70 ausgestattet. Im einzelnen nicht dargestellte Schrauben oder dergleichen Befestigungsmittel legen dabei den Drehrahmen 70 an dem Antrieb des Bondkopfes 12 fest.

Mit dieser Vorrichtung wird ein Verfahren zum Drahtbonden ausgeführt, dessen Anfangsphase in Fig. 4 skizziert ist. Dabei wird der Draht 22 auf im einzelnen nicht dargestellte Weise von dem Bondkopf 12 mitgenommen bzw. bei hinreichend hoher Steifigkeit durch das Drahtführungsröhrchen 36 nachgeschoben. Der Verfahrensablauf erfolgt dabei unter Verwendung einer Vorrichtung, bei der das Drahtmesser 30 in Drahtzuführungsrichtung hinter dem Stempel 20 am Bondkopf 12 angebracht ist.

Der Ablauf ist an sich - etwa aus der EP 0 649 701 B1 der Anmelderin - bekannt und wird daher hier in den weiteren Schritten nicht erläutert. Fig. 4 zeigt den sogenannten "touch-down" des am Bondkopf 12 angeordneten und ultraschallerregten Stempels 20 unter Ausbildung eines ersten Bonds 76. Der Stempel 20 ragt zu diesem Zweck über das Messer 30 und das Führungsröhrchen bzw. die Führungshülse 38 hinaus, so dass das Messer 30 auf den Draht noch nicht einwirkt.

Fig. 5 zeigt schematisch in art eines Funktions-Blockschaltbildes, eine Überwachungsund Steueranordnung 100 zur Überwachung und selbsttätigen Nachstellung der räumlichen Lage der oben erwähnten wesentlichen Werkzeug-Komponenten des (in Fig. 5 nur symbolisch dargestellten) Bondkopfes 12, nämlich des Stempels oder Bondkeils 20, des Messers 30 und des Drahtführungsröhrchens 36 (sämtlich in Fig. 5 nicht einzeln dargestellt).

Die Überwachungs- und Steueranordnung 100 umfasst zwei den Arbeitsbereich des Bondkopfes 12 von verschiedenen Punkten (in der beispielhaften Darstellung aus zueinander senkrechten Richtungen) erfassende Kameras 101, 103 mit jeweils nachgeordneter Primär-Bild-Verarbeitungseinrichtung 105 bzw. 107 und Mustererkennungseinrichtung 109 bzw. 111, mit zugeordnetem Komponenten-Musterspeicher 113 bzw. 115. Durch diese Bildverarbeitungskomponenten erfolgt zunächst eine Bildbearbeitung im Sinne üblicher Techniken, etwa Störbefreiung durch Filterung, Kantenbetonung etc. in den Einheiten 105, 107 sowie Mustererkennung der relevanten Werkzeuge des Bondkopfes in den Einheiten 109, 111, anhand von in den Speichern 113, 115 vorgespeicherten Konturen-Mustern der in dem Bondkopf 12 eingesetzten Komponenten Stempel, Messer und Bonddrahtführung.

Die Ausgänge der Mustererkennungseinheiten 109, 111 sind mit drei Positionsdaten-Berechnungseinheiten 117, 119 und 121 zur Berechnung der Positionsdaten des Stempels, des Messers bzw. der Bonddrahtführung verbunden. Die Einheiten 105 bis 121 bilden in der hier beschriebenen Zuordnung eine Bildverarbeitungseinrichtung 123, deren Aufbau und Arbeitsweise grundsätzlich - unabhängig von der Spezifik der hier bestehenden Bildverarbeitungsaufgabe - dem Fachmann bekannt ist und daher hier keiner genaueren Beschreibung bedarf.

Ausgangsseitig ist die für den Stempel (wedge) zuständige Positionsdaten-Berechnungseinheit 117 mit einer ersten Vergleichereinheit 125 verbunden, die für das Messer zuständige Positionsdaten-Berechnungseinheit 119 ist mit einer zweiten Vergleichereinheit 127 verbunden, und die zur Berechnung der Lage der Bonddrahtführung vorgesehene Positionsdaten-Berechnungseinheit 121 ist mit einer dritten Vergleichereinheit 129 eingangsseitig verbunden. Die Vergleichereinheiten 125, 127 und 129 sind des weiteren steuerungsmäßig mit einer Vergleichs-Steuerung 131 verbunden, die den Überwachungsbetrieb der Gesamtanordnung 100 steuert.

Über weiter Signaleingänge sind die erste bis dritte Vergleichereinheit 125 bis 129 mit einem ersten bis dritten (nicht gesondert bezeichneten) Speicherbereich eines Solldatenspeichers 133 verbunden, in denen Soll-Positionsdatensätze des Stempels, des Messers und der Bonddrahtführung als Vergleichsgrundlage für eine Vergleichsverarbeitung in den Einheiten 125, 127 und 129 gespeichert sind. Die Vergleichereinheiten sind, gemäß den heutigen technischen Möglichkeiten, zu einer intelligenten Vergleichs-Verarbeitung unter Berücksichtigung jeweils mehrerer vorgespeicherter Solldatensätze und vorbestimmter Toleranzen der räumlichen Lage der relevanten Werkzeuge ausgebildet. Derartige Komponenten sind kommerziell verfügbar, und ihre Programmierung anhand vorgegebener Lage- und Toleranz-Konstellationen der relevanten Werkzeuge eines Drahtbonders liegt im Rahmen fachmännischen Handelns.

Die erste bis dritte Vergleichereinheit 125 bis 129 sind ausgangsseitig einerseits mit einer Alarmsteuereinheit 135 und andererseits mit einer ersten bis dritten Positions-Stelleinheit 137, 139 bzw. 141 verbunden. Die Ausgangssignale der Vergleichereinheiten werden also zum einen zur Ausgabe von Alarmsignalen bei relevanter Dejustierung der Bondkopf-Komponenten und zum anderen zu deren Nachjustierung genutzt, wobei beide Reaktionsmöglichkeiten einzeln oder in Kombination miteinander aktiviert sein können. Auch die Positions-Stelleinheiten 137, 139 und 141 sind mit den entsprechenden Speicherbereichen des Solldatenspeichers 133 verbunden, um von dort Soll-Positionsdaten des jeweiligen Werkzeuges als Basis für die auszuführende Nachjustierung zu erhalten.

Wie weiter oben angemerkt, kann in Reaktion auf die Erfassung von Fehlstellungen eines oder mehrerer der relevanten Werkzeuge neben der Ausgabe eines Alarms und einer Nachjustierung der Position der jeweiligen Komponente auch eine Beeinflussung weiterer Parameter des Bondprozesses vorgesehen sein; auf die bildliche Darstellung dieser Möglichkeit wurde aber im Interesse der Übersichtlichkeit der Figur verzichtet. Aus dem gleichen Grunde wurde auf die Darstellung von Speicher- und Verarbeitungsmitteln zur Speicherung und Verarbeitung von Abbildern der einzelnen Werkzeuge bzw. eines in bestimmten Schritten des Bondprozesses vorhandenen überstehenden Endes des Bonddrahtes (tail) hier verzichtet; eine um entsprechende Komponenten ergänzte Anordnung kann der Fachmann aufgrund der obigen Erläuterungen schaffen.

Die Ausführung der Erfindung ist nicht auf das oben beschriebene Beispiel und die in diesem Zusammenhang hervorgehobenen Aspekte beschränkt, sondern ebenso in einer Vielzahl von Abwandlungen möglich, die im Rahmen der folgenden Anprüche liegen. Abwandlungen sind insbesondere hinsichtlich der Art der Bildverarbeitung im engeren Sinne sowie hinsichtlich der nachgeschalteten Vergleichs-Verarbeitung möglich, wobei speziell eine weitgehende vergleichende Bildverarbeitung an die Stelle der oben erwähnten Vergleichs-Bearbeitung von Ist-Positionsdatensätzen und Soll-Positionsdatensätzen treten kann.

## Patentansprüche

1. Drahtbonder (1c) mit einem Bondkopf (12), der ein Bondwerkzeug (20) und eine Bonddrahtführung (36) und eine Bonddraht-Schneidvorrichtung aufweist, die ein Messer (30) zum Abtrennen des über einen Bondkontakt überstehenden Abschnittes eines Bonddrahtes (22) umfasst, wobei der Drahtbonder eine Kamera (101,103) mit nachgeschalteter Bildverarbeitungseinrichtung (123) zur Aufnahme und Verarbeitung eines Bildes seines Arbeitsbereiches an einem Werkstück aufweist, wobei
der Bildverarbeitungseinrichtung Speichermittel (133) zur Speicherung von Solldaten bzw. Sollbildern mindestens einer Soll-Position des Bondwerkzeuges und/oder der Bonddrahtführung und/oder des Messers und/oder von Lagebeziehungen zwischen mindestens zweien dieser Komponenten oder zwischen mindestens einer dieser Komponenten und einer Substratoberfläche oder eines überstehenden Bonddraht-tails zu Beginn und/oder in mindestens einer Wirkphase eines Bondprozesses sowie
eine Vergleichs-Steuerung (131) und
eingangsseitig mit den Speichermitteln einerseits und der Bildverarbeitungseinrichtung (123) andererseits verbundene Vergleichermittel (125-129) zum Vergleich der Solldaten oder Sollbilder mit Positionsdaten oder Ist-Bildern der entsprechenden Komponenten oder des Bonddraht-tails in einer aktuellen Position und zur Ausgabe eines eine signifikante Abweichung zwischen Solldaten und Positionsdaten bzw. Sollbildern und Bildern kennzeichnenden Steuer- oder Warnsignals zugeordnet sind,
**dadurch gekennzeichnet,dass**
die Speichermittel (133) mindestens einen ersten, zweiten und dritten Speicherbereich zur Speicherung on Solldaten bzw. Sollbildern des Bondwerkeuges (20), der Bonddrahtführung (36) bzw. des Messers (30) und
die Vergleichermittel mindestens eine erste, zweite und dritte Vergleichereinheit (125,127,129) zum Vergleich der im ersten bis dritten Speicherbereich gespeicherten Solldaten bzw. Sollbilder mit Positionsdaten bzw. Bildern des Bondwerkzeuges, der Bonddrahtführung und des Messers umfassen und
der ersten bis dritten Vergleichereinheit eine logische Verarbeitungseinheit (135) zur Verknüpfung von separaten Ausgangssignalen der Vergleichereinheiten nachgeschaltet ist, die zur Ausgabe eines Steuer- bzw. Warnsignals ausgebildet ist,
wenn eine vorbestimmte Kombination von Ausgangssignalen der ersten bis dritten Vergleichereinheit vorliegt.

2. Drahtbonder nach Anspruch 1,
**dadurch gekennzeichnet, dass**
die Speichermittel (133) zur Speicherung jeweils mehrerer Sätze Solldaten oder mehrerer Sollbilder des Bondwerkzeuges (26) und/oder der Bonddrahtführung (36) und/oder des Messers (30) und/oder der tail-Länge in zulässigen Betriebslagen und/oder Zuständen und
die Vergleichermittel (125-129) zur Vergleichs-Verarbeitung der mehreren Solldatensätze oder Sollbilder mit jeweils einem Positionsdatensatz oder Bild nach einem vorbestimmten Vergleichsalgorithmus ausgebildet sind, welcher die Ausgabe eines Steuer- bzw. Warnsignals an eine vorbestimmte Menge von Abweichungen zwischen Solldaten und Positionsdaten bzw. Sollbildern und Bildern knüpft.

3. Drahtbonder nach einem der vorangehenden Ansprüche,
**dadurch gekennzeichnet, dass**
in den Speichermitteln (133) als Solldaten Höhen- und/oder Neigungswerte des Bondwerkzeuges (20) bzw. der Bonddrahtführung (36) bzw. Messers (30) und/oder Abstandswerte und/oder Winkeldifferenzen zwischen mindestens zweien dieser Komponenten und/oder einer dieser und der Substratoberfläche (14,16) gespeichert sind und
dass die Bildverarbeitungseinrichtung (123) Positionsdaten-Berechnungsmittel (117-121) zur Berechnung eines Positionsdatensatzes entsprechender aktueller Höhenund/oder Neigungswerte und/oder Abstandswerte und/oder Winkeldifferenzen aufweist, welche ausgangsseitig mit einem Eingang der Vergleichermittel (125-129) verbunden sind.

4. Drahtbonder nach einem der Ansprüche 1 bis 3,
**dadurch gekennzeichnet dass** ,
die Bildverarbeitungseinheit (123) und/oder die Vergleichermittel (125-129) Mustererkennungsmittel zur Erkennung eines Umrisses mindestens einer der Komponenten Bondwerkzeug (20), Bonddrahtführung (36) und Messer (30) und/oder eines Bonddraht-tails in einem aktuellen Bild zur Gewinnung eines Ist-Musters und Musterverarbeitungsmittel zur Vergleichs-Verarbeitung des Ist-Musters mit einem in den Speichermitteln als Sollbild gespeicherten Soll-Musters des oder der entsprechenden Komponente(n), insbesondere durch Verschiebung und/oder Drehung von Musterelementen, und zur Gewinnung des Steuer- bzw. Warnsignals aus Verarbeitungs-Steuersignalen der Vergleichs-Verarbeitung aufweist.

5. Drahtbonder nach einem der vorangehenden Ansprüche,
**dadurch gekennzeichnet, dass**
mit dem Ausgang der Vergleichermittel (125-129) eine Prozesssteuereinheit (137-141) zur Steuerung mindestens eines Parameters des Bondprozesses, insbesondere von geometrischen Einstellungen des Bondwerkzeuges (20), bzw. der Bonddrahtführung (36) bzw. des Messers (20) und/oder der Bond- bzw. Schneidkraft, in Abhängigkeit vom Ausgangssignal der Vergleichermittel verbunden ist.

6. Verfahren zum Betrieb eines Drahtbonders, mit einem Bondkopf, der ein Bondwerkzeug und eine Bonddrahtführung und eine Bonddraht-Schneidvorrichtung aufweist, die ein Messer zum Abtrennen des über einen Bondkontakt überstehenden Abschnittes eines Bonddrahtes umfasst, wobei der Drahtbonder eine Kamera mit nachgeschalteter Bildverarbeitungseinrichtung zur Aufnahme und Verarbeitung eines Bildes seines Arbeitsbereiches an einem Werkstück aufweist, mit den Schritten:
Speichern von Solldaten bzw. Sollbildern mindestens einer Soll-Position des Bondwerkzeuges und/oder der Bonddrahtführung und/oder des Messers und/oder von Lagebeziehungen zwischen mindestens zweien dieser Komponenten oder zwischen mindestens einer dieser Komponenten und einer Substratoberfläche oder eines überstehenden Bonddraht-tails zu Beginn und/oder in mindestens einer Wirkphase eines Bondprozesses,
Aufnehmen eines aktuellen Bildes des Arbeitsbereiches, welches mindestens eine der Komponenten Bondwerkzeug, Bonddrahtführung und Messer in Relation zu mindestens einer anderen Komponente oder einer Substratoberfläche oder den Bondraht-tail zeigt, und wahlweise Verarbeitung dieses Bildes zur Gewinnung von Positionsdaten der oder jeder abgebildeten Komponente,
Vergleichen mindestens eines Sollbildes oder Solldatensatzes mit dem aktuellen Bild oder Positionsdatensatz und
Ausgabe eines Steuer- oder Warnsignals im Falle der Feststellung einer signifikanten Abweichung zwischen Sollbild und aktuellem Bild oder Solldätensatz oder Positionsdatensatz,
**dadurch gekennzeichnet, dass**
der Speicher-Schritt das getrennte Speichern von Solldaten bzw. Sollbildern des Bondwerkzeuges, der Bonddrahtführung und des Messers in separaten Speicherbereichen der Speichermittel und
der Vergleichs-Schritt das getrennte Vergleichen der separat gespeicherten Sollbilder bzw. Solldaten mit aktuellen Bildern bzw. Positionsdaten der entsprechenden Komponente(n) umfasst und
nach dem Vergleichs-Schritt ein logischer Verarbeitungsschritt der Verknüpfung der in den Teilschritten des Vergleichs-Schrittes gewonnenen Ausgangssignale gemäß einer vorgegebenen logisch-kombinatorischen Verknüpfung ausgeführt wird.

7. Betriebsverfahren nach Anspruch 6,
**dadurch gekennzeichnet, dass**
im Speicher-Schritt jeweils mehrere Sätze Solldaten oder mehrere Sollbilder des Bondwerkzeuges und/oder der Bonddrahtführung und/oder des Messers oder des Bonddraht-tails in zulässigen Betriebslagen gespeichert und
im Vergleichs-Schritt eine Vergleichs-Verarbeitung der mehreren Solldatensätze oder Sollbilder mit jeweils einem aktuellen Bild oder Positionsdatensatz nach einem vorbestimmten Vergleichsalgorithmus ausgeführt wird, welcher die Ausgabe eines Steuer- bzw. Warnsignals an eine vorbestimmte Menge von Abweichungen zwischen Solldaten und Positionsdaten bzw. Sollbildern und Bildern knüpft.

8. Betriebsverfahren nach Anspruche 6 oder 7,
**dadurch gekennzeichnet, dass**
im Speicherschritt als Solldaten Höhen- und/oder Neigungswerte des Bond-werkzeuges bzw. der Bonddrahtführung bzw. Messers und/oder Abstandswerte und/oder Winkeldifferenzen zwischen mindestens zweien dieser Komponenten und/oder einer dieser und der Substratoberfläche gespeichert werden und in einem Verarbeitungsschritt ein Positionsdatensatz mit entsprechenden aktuellen Höhen- und/oder Neigungswerten und/oder Abstandswerten und/oder Winkeldifferenzen aus dem aktuellen Bild berechnet wird.

9. Betriebsverfahren nach einem der Ansprüche 6 bis 8,
**dadurch gekennzeichnet, dass** im Vergleichs-Schritt oder einem Verarbeitungs-Schritt eine Erkennung eines Umrisses mindestens einer der Komponenten Bondwerkzeug, Bonddrahtführung und Messer oder des Bonddraht-tails in einem Mustererkennungsverfahren in einem aktuellen Bild zur Gewinnung eines Ist-Musters ausgeführt wird und der Vergleichs-Schritt eine Vergleichs-Verarbeitung des Ist-Musters mit einem in den Speichermitteln als Sollbild gespeicherten Soll-Muster der entsprechenden Komponente(n) insbesondere durch Verschiebung und/oder Drehung von Musterelementen, durchgeführt und
ein ausgegebenes Steuer- bzw. Warnsignal aus Verarbeitungs-Steuersignalen der Vergleichs-Verarbeitung abgeleitet wird.

10. Betriebsverfahren nach einem der Ansprüche 6 bis 9,
**dadurch gekennzeichnet, dass**
das Ausgangssignal der Vergleichermittel in einer Prozesssteuereinheit zur Steuerung mindestens eines Parameters des Bondprozesses, insbesondere von geometrischen Einstellungen des Bondwerkzeuges bzw. der Bonddrahtführung bzw. des Messers und/oder der Bond- bzw. Schneidkraft, in Abhängigkeit vom Ausgangssignal der Vergleichermittel benutzt wird.

## Claims

1. Wire bonder (10) having a bonding head (12) comprising a bonding tool (20) and a bonding wire guide (36) and a bonding wire cutting apparatus which comprises a blade (30) for separating that portion of a bonding wire (22) which projects beyond a bonding contact, the wire bonder having a camera (101, 103) with a downstream image-processing device (123) for recording and processing an image of the working region of the bonder at a workpiece, with the image-processing device there being associated storage means (133) for storing desired data and/or desired images of at least one desired position of the bonding tool and/or of the bonding wire guide and/or of the blade and/or positional relationships between at least two of those components or between at least one of those components and a substrate surface or a projecting bonding wire tail at the start of and/or in at least one work phase of a bonding process and also
a comparison control (131) and
comparator means (125 - 129), connected on the input side to, on the one hand, the storage means and, on the other hand, the image-processing device (123), for comparing the desired data or desired images with positional data or actual images of the corresponding components or of the bonding wire tail in an actual position and for outputting a control or warning signal indicative of a significant discrepancy between desired data and positional data and/or desired images and images,
**characterised in that**
the storage means (133) comprise at least first, second and third storage regions for the storage of desired data and/or desired images of the bonding tool (20), of the bonding wire guide (36) and/or of the blade (30), and
the comparator means comprise at least first, second and third comparator units (125, 127, 129) for comparing the desired data and/or desired images stored in the first to third storage regions with positional data and/or images of the bonding tool, of the bonding wire guide and of the blade, and
downstream of the first to third comparator units there is connected a logic processing unit (135) for linking separate output signals of the comparator units which is arranged for the outputting of a control and/or warning signal when a predetermined combination of output signals of the first to third comparator units is present.

2. Wire bonder according to claim 1,
**characterised in that**
the storage means (133) are arranged for the storage of, in each case, a plurality of sets of desired data or a plurality of desired images of the bonding tool (20) and/or of the bonding wire guide (36) and/or of the blade (30) and/or of the tail length in permissible operating positions and/or states, and
the comparator means (125 -129) are arranged for the comparative processing of the plurality of desired data sets or desired images with, in each case, a positional data set or image according to a predetermined comparison algorithm which links the outputting of a control and/or warning signal to a predetermined set of discrepancies between desired data and positional data and/or desired images and images.

3. Wire bonder according to one of the preceding claims,
**characterised in that**
in the storage means (133) there are stored, as desired data, height values and/or inclination values of the bonding tool (20) and/or of the bonding wire guide (36) and/or of the blade (30) and/or spacing values and/or angular differences between at least two of those components and/or one thereof and the substrate surface (14, 16), and
**in that** the image-processing device (123) comprises positional data computation means (117 - 121) for computing a positional data set of corresponding actual height values and/or inclination values and/or spacing values and/or angular differences, which computation means are connected on the output side to an input of the comparator means (125 - 129).

4. Wire bonder according to one of claims 1 to 3,
**characterised in that**
the image-processing unit (123) and/or the comparator means (125 - 129) comprises pattern recognition means for recognition of an outline of at least one of the components that are the bonding tool (20), the bonding wire guide (36) and the blade (30) and/or of a bonding wire tail in an actual image for obtaining an actual pattern and
pattern-processing means for comparative processing of the actual pattern with a desired pattern of the corresponding component(s) that is stored as a desired image in the storage means, especially by means of translation and/or rotation of pattern elements, and for obtaining the control and/or warning signal from processing control signals of the comparative processing.

5. Wire bonder according to one of the preceding claims,
**characterised in that**
to the output of the comparator means (125 - 129) there is connected a process control unit (137 - 141) for controlling at least one parameter of the bonding process, especially geometric settings of the bonding tool (20) and/or of the bonding wire guide (36) and/or of the blade (20) and/or the bonding force and/or cutting force, in dependence on the output signal of the comparator means.

6. Method of operating a wire bonder having a bonding head comprising a bonding tool and a bonding wire guide and a bonding wire cutting apparatus which comprises a blade for separating that portion of a bonding wire which projects beyond a bonding contact, the wire bonder having a camera with a downstream image-processing device for recording and processing an image of the working region of the bonder at a workpiece, comprising the steps: storing desired data and/or desired images of at least one desired position of the bonding tool and/or of the bonding wire guide and/or of the blade and/or positional relationships between at least two of those components or between at least one of those components and a substrate surface or a projecting bonding wire tail at the start of and/or in at least one work phase of a bonding process,
recording an actual image of the working region, which image shows at least one of the components that are the bonding tool, bonding wire guide and blade in relation to at least one other component or a substrate surface or the bonding wire tail and, optionally, processing that image for obtaining positional data of the or of each imaged component,
comparing at least one desired image or desired data set with the actual image or positional data set, and
outputting a control or warning signal in the event of finding a significant discrepancy between the desired image and actual image or desired data set or positional data set,
**characterised in that**
the storing step comprises separately storing desired data and/or desired images of the bonding tool, of the bonding wire guide and of the blade in separate storage regions of the storage means, and
the comparing step comprises separately comparing the separately stored desired images and/or desired data with actual images and/or positional data of the corresponding component(s), and
after the comparing step there is carried out a logic processing step of linking the output signals obtained in the partial steps of the comparing step, in accordance with a prespecified logic-combinational operation.

7. Method of operation according to claim 6,
**characterised in that**
in the storing step there are stored, in each case, a plurality of sets of desired data or a plurality of desired images of the bonding tool and/or of the bonding wire guide and/or of the blade or of the bonding wire tail in permissible operating positions, and
in the comparing step there is carried out comparative processing of the plurality of desired data sets or desired images with, in each case, an actual image or positional data set according to a predetermined comparison algorithm which links the outputting of a control and/or warning signal to a predetermined set of discrepancies between desired data and positional data and/or desired images and images.

8. Method of operation according to claim 6 or 7,
**characterised in that**
in the storing step there are stored, as desired data, height values and/or inclination values of the bonding tool and/or of the bonding wire guide and/or of the blade and/or spacing values and/or angular differences between at least two of those components and/or one thereof and the substrate surface, and in a processing step there is computed from the actual image a positional data set comprising corresponding actual height values and/or inclination values and/or spacing values and/or angular differences.

9. Method of operation according to one of claims 6 to 8,
**characterised in that**
in the comparing step or in a processing step there is carried out, in a pattern recognition method, recognition of an outline of at least one of the components that are the bonding tool, the bonding wire guide and the blade or of the bonding wire tail in an actual image for obtaining an actual pattern, and
the comparing step implements comparative processing of the actual pattern with a desired pattern of the corresponding component(s) that is stored as a desired image in the storage means, especially by means of translation and/or rotation of pattern elements, and
an outputted control and/or warning signal is derived from processing control signals of the comparative processing.

10. Method of operation according to one of claims 6 to 9,
**characterised in that**
the output signal of the comparator means is used in a process control unit for controlling at least one parameter of the bonding process, especially geometric settings of the bonding tool and/or of the bonding wire guide and/or of the blade and/or the bonding force and/or cutting force, in dependence on the output signal of the comparator means.

## Revendications

1. Contacteur de fil (10) avec une tête de contact (12) présentant un outil de contact (20) et un dispositif de guidage du fil de contact (36) ainsi qu'un dispositif de coupe du fil de contact comprenant une lame (30) pour séparer le segment d'un fil de contact (22) faisant saillie via au-delà d'un contact, le contacteur de fil présentant ici une caméra (101, 103) avec un dispositif de traitement d'image (123) connecté en aval permettant de prendre et de traiter une image de son domaine de travail sur une pièce usinée, dans lequel
des moyens de stockage (133) permettant de stocker les données de consigne ou les images de consigne au moins d'une position de consigne de l'outil de contact et/ou du dispositif de guidage du fil de contact et/ou de la lame et/ou des rapports de position entre au moins deux de ces composants ou entre au moins l'un de ces composants et la surface de substrat ou un segment du fil de contact faisant saillie au départ et/ou au moins au cours d'une phase active d'un procédé mise en contact ainsi qu'
une commande de comparaison (131) et
des moyens de comparaison (125-129) reliés d'une part, côté entrée, aux moyens de stockage et d'autre part au dispositif de traitement d'image (123) permettant de comparer les données de consigne ou les images de consigne avec des données de position ou des images réelles des composants correspondants ou du segment de fil de contact dans une position actuelle et permettant d'émettre un signal de contrôle ou d'avertissement caractérisant un écart significatif entre les données de consigne et les données de position ou entre les images de consigne et les images sont associés au dispositif de traitement d'image,
**caractérisé en ce que** les moyens de stockage (133) comprennent au moins une première, une deuxième et une troisième zone de stockage permettant de stocker les données de consigne ou les images de consigne de l'outil de contact (20), du dispositif de guidage du fil de contact (36) ou de la lame (30) et
les moyens de comparaison comprennent au moins une première, une deuxième et une troisième unité de comparaison (125, 127, 129) permettant de comparer les données de consigne ou les images de consigne stockées dans la première à la troisième zone de stockage avec les données de position ou les images de l'outil de contact, du dispositif de guidage du fil de contact ou de la lame et **en ce que**
une unité de traitement logique (135) est connectée en aval de la première à la troisième unité de comparaison pour combiner les signaux de sortie distincts des unités de comparaison, cette unité de traitement logique étant conçue pour émettre un signal de contrôle ou d'avertissement s'il existe une combinaison prédéfinie de signaux de sortie de la première à la troisième unité de comparaison.

2. Contacteur de fil selon la revendication 1,
**caractérisé en ce que**
les moyens de stockage (133) sont conçus pour stocker respectivement plusieurs ensembles de données de consigne ou plusieurs images de consigne de l'outil de contact (20) et/ou du dispositif de guidage du fil de contact (36) et/ou de la lame (30) et/ou de la longueur de segment dans des positions et/ou des états de fonctionnement fiables et
**en ce que** les moyens de comparaison (125-129) sont conçus pour traiter par comparaison les différents ensembles de données de consigne ou les images de consigne avec respectivement un ensemble de données de position ou une image selon un algorithme de comparaison prédéfini qui associe l'émission d'un signal de contrôle ou d'avertissement à un nombre prédéfini d'écarts entre les données de consigne et les données de position ou entre les images de consigne et les images.

3. Contacteur de fil selon l'une des revendications précédentes,
**caractérisé en ce que**,
dans les moyens de stockage (133), les valeurs de hauteur et/ou d'inclinaison de l'outil de contact (20) ou du dispositif de guidage du fil de contact (36) ou de la lame (30) et/ou les valeurs de distance et/ou les écarts angulaires entre au moins deux de ces composants et/ou l'un de ces composants et la surface du substrat (14,16) sont enregistrés sous forme de données de consigne et **en ce que**
le dispositif de traitement d'image (123) présente des moyens de calcul des données de position (117-121) permettant de calculer un ensemble de données de position avec des valeurs actuelles correspondantes de hauteur et/ou d'inclinaison et/ou des valeurs de distance et/ou des écarts angulaires, ces moyens étant reliés côté sortie à une entrée des moyens de comparaison (125-129).

4. Contacteur de fil selon l'une des revendications 1 à 3,
**caractérisé en ce que**
l'unité de traitement d'image (123) et/ou les moyens de comparaison (125-129) présente(nt) des moyens de reconnaissance d'échantillon permettant de reconnaître un contour d'au moins l'un des composants que sont l'outil de contact (20), le dispositif de guidage du fil de contact (36) et la lame (30) et/ou d'un segment de fil de contact dans une image actuelle afin d'obtenir un échantillon réel et un moyen de traitement d'échantillon pour traiter par comparaison l'échantillon réel et un échantillon de consigne du ou des composants correspondants stocké sous forme d'image de consigne dans les moyens de stockage, en particulier grâce à un déplacement en translation et/ou une rotation d'éléments d'échantillon et afin d'obtenir le signal de contrôle ou d'avertissement à partir des signaux de contrôle de traitement impliqué dans le traitement par comparaison.

5. Contacteur de fil selon l'une des revendications précédentes
**caractérisé en ce que**
une unité de contrôle du processus (137-147) est reliée, en fonction du signal de sortie des moyens de comparaison, à la sortie des moyens de comparaison (125-129) pour contrôler au moins un paramètre du procédé de mise en contact, en particulier à partir des paramètres géométriques de l'outil de contact (20) ou du dispositif de guidage du fil de contact (36) ou de la lame (30) et/ou de la force de contact ou de coupe.

6. Procédé de fonctionnement d'un contacteur de fil avec une tête de contact présentant un outil de contact et un dispositif de guidage du fil de contact ainsi qu'un dispositif de coupe du fil de contact comprenant une lame pour séparer le segment d'un fil de contact faisant saillie au-delà d'un contact, le contacteur de fil présentant ici une caméra avec un dispositif de traitement d'image connecté en aval permettant de prendre et de traiter une image de son domaine de travail sur une pièce usinée en exécutant les étapes suivantes :
stockage des données de consigne ou des images de consigne au moins d'une position réelle de l'outil de contact et/ou du dispositif de guidage du fil de contact et/ou de la lame et/ou des rapports de position entre au moins deux de ces composants ou entre au moins l'un de ces composants et une surface de substrat ou un segment du fil de contact faisant saillie au départ et/ou au moins au cours d'une phase active d'un procédé de mise en contact,
prise d'une image actuelle du domaine de travail montrant au moins l'un des composants qui sont l'outil de contact, le dispositif de guidage du fil de contact et la lame par rapport au moins à un autre des composants ou à une surface de substrat ou au segment du fil de contact, et au choix, traitement de cette image afin d'obtenir les données de position du composant ou de chaque composant représenté,
comparaison d'au moins une image de consigne ou d'un ensemble de données de consigne avec l'image actuelle ou l'ensemble de données de position actuel et
émission d'un signal de contrôle ou d'avertissement dans le cas de la constatation d'un écart significatif entre l'image de consigne et l'image actuelle ou l'ensemble de données de consigne ou l'ensemble de données de position,
**caractérisé en ce que**
l'étape de stockage comprend le stockage à part des données de consigne ou des images de consigne de l'outil de contact, du dispositif de guidage du fil de contact et de la lame dans des zones de stockage distinctes des moyens de stockage et
**en ce que** l'étape de comparaison comprend la comparaison séparée des images de consigne ou des données de consigne stockées à part avec les images actuelles ou les données de position actuelles du ou des composants correspondants et
**en ce que**, après l'étape de comparaison, une étape de traitement logique de la combinaison des signaux de sortie obtenus lors des étapes partielles de l'étape de comparaison est exécutée conformément à une combinaison logique prédéfinie.

7. Procédé de fonctionnement selon la revendication 6,
**caractérisé en ce que**,
au cours de l'étape de stockage, plusieurs ensembles de données de consigne ou plusieurs images de consigne de l'outil de contact et/ou du dispositif de guidage du fil de contact et/ou de la lame ou encore du segment de fil de contact sont stockés dans des positions de fonctionnement fiables et **en ce que**,
au cours de l'étape de comparaison, un traitement par comparaison des différents ensembles de données de consigne ou d'images de consigne avec respectivement une image actuelle ou un ensemble de données de position est exécuté selon un algorithme de comparaison prédéfini qui associe l'émission d'un signal de contrôle ou d'avertissement à un nombre prédéfini d'écarts entre les données de consigne et les données de position ou entre les images de consigne et les images.

8. Procédé de fonctionnement selon la revendication 6 ou 7,
**caractérisé en ce que**,
au cours de l'étape de stockage, les valeurs de hauteur et/ou d'inclinaison de l'outil de contact ou du dispositif de guidage du fil de contact ou de la lame et/ou les valeurs de distance et/ou les écarts angulaires entre au moins deux de ces composants et/ou l'un de ces composants et la surface du substrat sont enregistrés sous forme de données de consigne et **en ce que**, au cours d'une étape de traitement, un ensemble de données de position est calculé, à partir de l'image actuelle, avec les valeurs de hauteur et/ou d'inclinaison correspondantes et/ou les valeurs de distance correspondantes et/ou les écarts angulaires correspondants.

9. Procédé de fonctionnement selon l'une des revendications 6 à 8,
**caractérisé en ce que**,
au cours de l'étape de comparaison ou au cours d'une étape de traitement, une reconnaissance d'un contour d'au moins l'un des composants que sont l'outil de contact, le dispositif de guidage du fil de contact et la lame ou du segment de fil de contact est assurée lors d'un procédé de reconnaissance d'échantillon dans une image actuelle afin d'obtenir un échantillon réel et **en ce que** l'étape de comparaison correspond à l'exécution d'un traitement par comparaison de l'échantillon réel avec un échantillon de consigne stocké sous forme d'image de consigne dans les moyens de stockage du ou des composants correspondants, en particulier grâce à un déplacement en translation et/ou une rotation d' éléments d'échantillon et
**en ce qu'**un signal de contrôle ou d'avertissement est émis en étant dérivé à partir des signaux de contrôle de traitement impliqués dans le traitement par comparaison.

10. Procédé de fonctionnement selon l'une des revendications 6 à 9,
**caractérisé en ce que**
le signal de sortie des moyens de comparaison est utilisé dans une unité de contrôle du processus pour contrôler au moins un paramètre du procédé de mise en contact, en particulier des paramètres géométriques de l'outil de contact ou du dispositif de guidage du fil de contact ou de la lame et/ou de la force de contact ou de coupure, en fonction du signal de sortie des moyens de comparaison.
